# EUROPÄISCHE PATENTSCHRIFT

(11) **EP 1 468 398 B1**
(45) Veröffentlichungstag und Bekanntmachung des Hinweises auf die Patenterteilung: **01.06.2005**
(21) Anmeldenummer: 02792688.0
(22) Anmeldetag: 23.12.2002
(51) Int. Cl.: G06K 19/077

(54) **TRÄGERSUBSTRAT FÜR EIN CHIPMODUL, CHIPMODUL UND CHIPKARTE**
SUPPORT SUBSTRATE FOR A CHIP MODULE, CHIP MODULE AND CHIP CARD
SUBSTRAT DE SUPPORT POUR UN MODULE DE PUCE, MODULE DE PUCE ET CARTE PUCE

(30) Priorität: 24.01.2002 DE 10202727
(43) Veröffentlichungstag der Anmeldung: 20.10.2004
(73) Patentinhaber: Infineon Technologies AG, 81669 München (DE)
(72) Erfinder: HEINEMANN, Erik, 93049 Regensburg (DE); PÜSCHNER, Frank, 93309 Kelheim (DE)
(74) Vertreter: Epping, Hermann, Fischer
(86) Internationale Anmeldenummer: PCT/DE2002/004713
(87) Internationale Veröffentlichungsnummer: WO 2003/063077

(56) Entgegenhaltungen:
- EP-A- 0 207 852
- EP-A- 0 766 197
- FR-A- 2 439 478

## Beschreibung

Die Erfindung betrifft ein elektrisch isolierendes Trägersubstrat für ein Chipmodul, das auf einer Kontaktseite eine Kontaktseitenmetallisierung mit elektrisch voneinander getrennten ersten Kontaktflächen und auf einer der Kontaktseitenmetallisierung gegenüberliegenden Einsatzseite eine Einsatzseitenmetallisierung mit elektrisch voneinander getrennten zweiten Kontaktflächen aufweist, wobei zumindest einigen der ersten Kontaktflächen jeweils eine der zweiten Kontaktflächen zugeordnet ist. Die Erfindung betrifft weiterhin ein Chipmodul zum Einsetzen in einen Chipkartenkörper mit einem Trägersubstrat der genannten Art. Weiterhin wird eine Chipkarte mit einem Kartenkörper beschrieben, in dessen Oberfläche eine Kavität ausgebildet ist, in die ein Chipmodul der genannten Art eingebracht ist.

Elektrisch isolierende Trägersubstrate gemäß dem Oberbegriff des Anspruchs 1, sowie Chipmodule und Chipkarten der oben beschriebenen Art sind aus dem Stand der Technik bekannt z.B. aus EP 0 766 197. Anhand der Figur 2, die im Querschnitt ein in eine Kavität eines Kartenkörpers einer Chipkarte eingesetztes Chipmodul darstellt, soll der prinzipielle Aufbau derartiger Anordnungen beschrieben werden.
Ein Chipkartenkörper 50 weist in seiner Oberfläche 51 eine Kavität 52 auf. Die Kavität 52 ist zweistufig ausgebildet und besteht aus einer inneren Kavität 53 sowie einer im Durchmesser größeren äußeren Kavität 54, die jedoch weniger tief in den Kartenkörper 50 hineinreicht als die innere Kavität 53. In die Kavität 52 ist ein Chipmodul 1 derart eingebracht, daß dieses in etwa bündig mit der Oberfläche 51 der Chipkarte abschließt.

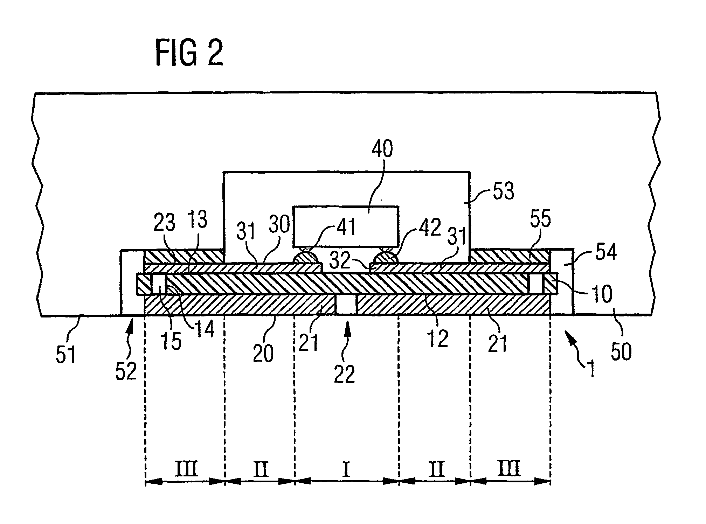

Das Chipmodul 1 besteht aus einem Trägersubstrat 10. Auf einer Kontaktflächenseite 12, ist eine Kontaktseitenmetallisierung 20 vorgesehen, die elektrisch voneinander getrennte erste Kontaktflächen 21 aufweist. Im Querschnitt der Figur 2 sind lediglich beispielhaft zwei erste Kontaktflächen 21 dargestellt. Auf einer der Kontaktseitenmetallisierung 20 gegenüberliegenden Einsatzseite 13 ist eine Einsatzseitenmetallisierung 30 vorgesehen. Diese verfügt ebenfalls über elektrisch voneinander getrennte zweite Kontaktflächen 31, von denen beispielhaft ebenfalls zwei dargestellt sind. Die zweiten Kontaktflächen 31 verlaufen im vorliegenden Ausführungsbeispiel im wesentlichen von einem Randbereich des Trägersubstrates 10 zu einem mittig angeordneten Bereich, der in der Figur 2 mit I bezeichnet ist. Bei diesem Bereich handelt es sich um einen Chipaufnahmebereich, in welchem ein Chip 40 von der Einsatzseite 13 her auf das Trägersubstrat aufgebracht wird.

Die elektrische Verbindung zwischen dem Chip 40 und den zweiten Kontaktflächen 31 erfolgt dabei in Flip-Chip-Technologie. Der Einsatzseite 13 zugewandte Kontaktpunkte 41 werden somit mittels Kontaktelementen 42 mit Kontaktstellen 32 auf den zweiten Kontaktflächen 31 elektrisch verbunden. Die Fläche des Chipaufnahmebereiches I ist ausschließlich durch die Fläche des auf das Trägersubstrat 1 aufzubringenden Chips 40 festgelegt. Aus der Querschnittsdarstellung der Figur 2 ist darüber hinaus gut ersichtlich, daß die innere Kavität 53 zur Aufnahme des Chips 40 dient.

Sofern es sich bei der dargestellten Chipkarte um eine standardisierte Chipkarte handelt, sind insgesamt zwischen sechs und zehn erste Kontaktflächen 21 auf der Kontaktseite des Trägersubstrates angeordnet. Zumindest einigen dieser ersten Kontaktflächen 21 sind zweite Kontaktflächen 31 zugeordnet.

Zwischen den einander zugeordneten Kontaktflächen 21, 31 ist im vorliegenden Ausführungsbeispiel eine elektrische Verbindung mittels eines Kontaktmaterialelementes 15 hergestellt. Das Kontaktmaterialelement 15 ist dabei als sogenannte Durchkontaktierung ausgebildet. Zu diesem Zweck weist das Trägersubstrat 10 eine Ausnehmung 14 auf, die mit einem Kontaktmaterial zur Bildung des Kontaktmaterialelementes 15 aufgefüllt ist.

Das Chipmodul 1 bzw. das Trägersubstrat 10 verfügt darüber hinaus über einen Modulmontagebereich III. In diesem Modulmontagebereich III ist das Chipmodul 1 bzw. das Trägersubstrat über ein Verbindungsmaterial 55 mit dem Boden der äußeren Kavität 54 mechanisch verbunden. Der Modulmontagebereich III erstreckt sich somit im wesentlichen in dem Bereich, in dem sich der Boden der äußeren Kavität 54 und das Trägersubstrat 10 überdecken.

Mit II ist ein Bereich gekennzeichnet, der weder einen Chipaufnahmebereich I noch einen Modulmontagebereich III darstellt. Dieser Bereich II ist somit durch den Bereich zwischen der Wandung der inneren Kavität 53 und dem Chip 40 definiert.

Figur 2 stellt einen üblichen Aufbau einer häufig eingesetzten Chipkarte dar. Bei der Konstruktion des Chipmoduls und beim Einbau desselben in eine Chipkarte wird dabei großes Augenmerk auf die mechanische Belastbarkeit gelegt. Beim Versand der Chipkarten auf dem Postweg werden diese nämlich über Briefsortieranlagen transportiert und sortiert. Dabei werden die in der Chipkarte befindlichen Chipmodule einem hohen mechanischen Biegestreß ausgesetzt, der durch schnelle Richtungsänderungen innerhalb der Briefsortieranlage bedingt ist. Aufgrund der hohen Durchlaufgeschwindigkeiten, häufigen Richtungswechsel über bewegliche Rollen, die üblicherweise einen Durchmesser von ca. 40 mm aufweisen, und anderen konstruktiven Merkmalen einer Briefsortieranlage ist das Chipmodul zudem sehr hohen kinetischen Kräften ausgesetzt.

Die auftretenden Kräfte können im Einzelfall dazu führen, daß entweder der Halbleiterchip oder die elektrische Verbindung zwischen dem Chip und den ersten Kontaktflächen beim Durchlaufen der Briefsortieranlage beschädigt werden. Es ist deshalb üblich, die auftretenden Kräfte durch Erhöhung des Modulbiegewiderstandes im Chip- und Verbindungsbereich zu entkräften. Gewöhnlich werden hierzu harte Abdeckmassen, die den Chip auf der Einsatzseite des Trägersubstrates umgeben, mit einem hohen Elastizitätsmodul eingesetzt. Zur Erhöhung des Modulbiegewiderstandes zur Entkräftung der im Chip- und Verbindungsbereich auftretenden Kräfte kann auch ein sogenannter Hotmelt-Klebstoff verwendet werden, der das Chipmodul 1 mit dem Boden der äußeren Kavität 54 verbindet. Dessen elastische Eigenschaften unterstützen die weiter oben genannte Maßnahme wirkungsvoll.

Die beschriebenen Maßnahmen kommen vor allem dann zur Geltung, wenn die elektrische Verbindung zwischen dem Chip und den zweiten Kontaktflächen mittels Bonddrähten erfolgt. Bei der neuerdings eingesetzten, in Figur zwei dargestellten Flip-Chip-Technologie werden jedoch anstatt der bislang verwendeten Trägersubstrate aus Epoxyd Trägersubstrate aus Polyester eingesetzt. Die bislang verwendeten Methoden zur Herstellung eines besonders mechanisch stabilen Chipmoduls können somit auch nicht mehr uneingeschränkt angewendet werden.

Die Aufgabe der vorliegenden Erfindung ist es daher, ein elektrisch isolierendes Trägersubstrat anzugeben, auf dem ein Chip mittels Flip-Chip-Technologie befestigbar ist und welches im Ergebnis ein besonders mechanisch stabiles Chipmodul ergibt. Weiterhin soll ein derartiges mechanisch stabiles Chipmodul angegeben werden.

Diese Aufgabe wird durch ein elektrisch isolierendes Trägersubstrat gemäß den Merkmalen des Anspruches 1 gelöst. Vorteilhafte Ausgestaltungen ergeben sich aus den abhängigen Ansprüchen. Erfindungsgemäß sollen sich die einander zugeordneten Kontaktflächen zumindest außerhalb des Chipaufnahmebereiches und außerhalb des Modulmontagebereiches vollständig überdecken.

Der Erfindung liegt die Erkenntnis zu Grunde, daß das Substrat aus Polyester einen geringen Biegewiderstand aufweist. Mit anderen Worten ist das Trägersubstrat sehr elastisch. Aufgrund dessen wirken bei einer Biegebeanspruchung auf den Chip selbst keine Kräfte. Die zwischen den ersten Kontaktflächen vorhandenen Isolationsschlitze, die üblicherweise als Sollbiegestellen wirken, können aufgrund des geringen Biegewiderstandes des Trägersubstrates keine schädliche Wirkung auf den Chip entfalten. Dies hat zur Folge, daß das Trägersubstrat kein Drehmoment auf den Chip bzw. die Kontaktseiten- und Einsatzseitenmetallisierung übertragen kann.

Die bei einer Biegebelastung auftretenden Kräfte wirken jedoch nunmehr unmittelbar auf die seitlich neben dem Chip gelegenen Metallisierungsflächen ein. Versuche haben gezeigt, daß insbesondere die auf der Einsatzseite liegenden zweiten Kontaktflächen reißen können, wenn diese über einen zwischen zwei ersten Kontaktflächen gelegenen Isolationsschlitz verlaufen. Ein solches Reißen der zweiten Kontaktflächen kann jedoch verhindert werden, wenn sich die einander zugeordneten Kontaktflächen zumindest außerhalb des Chipaufnahmebereiches und außerhalb des Modulmontagebereiches vollständig überdekken.

Es ist natürlich vorteilhaft, wenn sich die einander zugeordneten Kontaktflächen auch im Chipaufnahmebereich oder im Modulmontagebereich überdecken.

In einer weiteren vorteilhaften Ausgestaltung ist vorgesehen, daß je eine erste Kontaktfläche einer zweiten Kontaktfläche zugeordnet ist. Wenn, wie in einer weiteren Ausgestaltung der Erfindung vorgesehen, zwischen den einander zugeordneten Kontaktflächen mittels eines Kontaktmaterialelementes eine elektrische Verbindung hergestellt ist, kann jede erste Kontaktfläche eine elektrische Funktion übernehmen. Vorzugsweise sind die Kontaktmaterialelemente im Montagebereich des Trägersubstrates angeordnet.

Das erfindungsgemäße Chipmodul ist mit den Merkmalen des Anspruches 8 definiert. Es zeichnet sich dadurch aus, daß auf der Einsatzseite des Trägersubstrates zumindest ein Chip aufgebracht ist, der auf einer Hauptseite Kontaktpunkte aufweist, von denen zumindest einige über Kontaktelemente mit den zweiten Kontaktstellen elektrisch verbunden sind. Vorzugsweise sind die Kontaktelemente als Bumps ausgebildet, so daß eine Flip-Chip-Kontaktierung des Chips mit dem Trägersubstrat erfolgen kann.

Die erfindungsgemäße Chipkarte ist mit den Merkmalen des Anspruches 10 definiert. Die erfindungsgemäße Chipkarte weist einen Kartenkörper auf, in dessen Oberfläche eine Kavität ausgebildet ist. In diese ist ein Chipmodul der oben beschriebenen Art eingebracht, wobei eine mechanische Halterung des Chipmoduls an dem Kartenkörper über dessen Modulmontagebereich vorgesehen ist. Die mechanische Halterung erfolgt vorzugsweise über ein Verbindungsmaterial, wie beispielsweise einem Kleber. In einer bevorzugten Ausgestaltung ist die Kavität zweistufig ausgebildet und verfügt somit über eine innere und eine äußere Kavität. Die innere Kavität dient zur Aufnahme des Chips des Chipmodules und erstreckt sich dem gemäß weiter in den Kartenkörper hinein als die äußere Kavität. Der Boden der äußeren Kavität, auf den das Verbindungsmaterial zur mechanischen Halterung des Chipmodules aufgebracht wird, definiert den Modulmontagebereich.

Anhand der nachfolgenden Zeichnungen wird die Erfindung und deren Vorteile näher erläutert. Es zeigen:
- Figur 1: in der Draufsicht ein Ausführungsbeispiel eines erfindungsgemäßen Trägersubstrates bzw. Chipmodules und
- Figur 2: einen Querschnitt, aus dem die Anordnung eines Chipmodules in einem Chipkartenkörper ersichtlich wird.

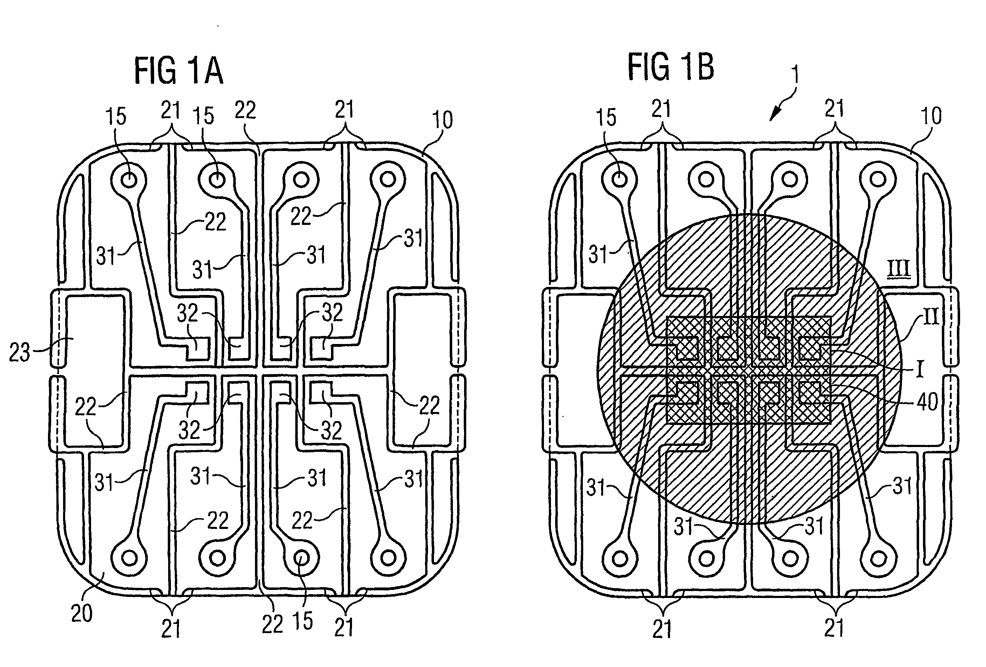

Die Figur 1 zeigt ein Ausführungsbeispiel eines erfindungsgemäßen Trägersubstrates bzw. eines Chipmodules in der Draufsicht. Anhand der Figur 1a soll nachfolgend der Aufbau des erfindungsgemäßen Trägersubstrates erläutert werden.

Gezeigt ist die Draufsicht auf die Kontaktflächenseite 12 des Trägersubstrates 10. Auf der Kontaktflächenseite 12 ist eine Kontaktflächenmetallisierung 20 aufgebracht, die acht erste Kontaktflächen 21 beinhaltet. Die Ausgestaltung der ersten Kontaktflächen 21 kann grundsätzlich beliebiger Natur sein. Im vorliegenden Ausführungsbeispiel sind diese spiegelsymmetrisch zu einer horizontalen und vertikalen Symmetrieachse ausgebildet. Die ersten Kontaktflächen 21 sind durch Isolationsschlitze 22 elektrisch voneinander getrennt. Die Isolationsschlitze 22 stellen potentielle Sollbiegestellen dar, insbesondere dann, wenn sie das Trägersubstrat vollständig durchqueren. Dies ist beispielsweise im Bereich der von oben nach unten verlaufenden Symmetrielinie des Trägersubstrates 10 der Fall. Die mit 23 gekennzeichneten Bereiche der Kontaktflächenmetallisierung 20 dienen dazu, potientielle Sollbiegestellen zu schwächen und haben vorliegend keine elektrische Funktion.

Auf der der Kontaktflächenseite 12 gegenüberliegenden Einsatzseite 13 ist eine Einsatzseitenmetallisierung 30 ausgebildet, die ebenfalls aus der Draufsicht erkennbar ist, und die über eine Mehrzahl an zweiten Kontaktflächen 31 verfügt. Die zweiten Kontaktflächen 31 verfügen dabei über Kontaktstellen 32, mit denen sie über eine Flip-Chip-Kontaktierung mit einem auf der Einsatzseite 13 aufzubringenden Chip kontaktiert werden können. Die zweiten Kontaktflächen 31 sind im gezeigten Ausführungsbeispiel in Form von Leiterzügen ausgebildet. Prinzipiell können die zweiten Kontaktflächen 31 jede beliebige Form aufweisen.

An den den Kontaktstellen 32 gegenüberliegenden Enden sind die zweiten Kontaktflächen 31 über ein Kontaktmaterialelement 15 elektrisch mit jeweils zugeordneten ersten Kontaktflächen 21 elektrisch verbunden. Die Ausgestaltung des Kontaktmaterialelementes 15 geht besser aus der Figur 2 hervor, welche bereits einleitend beschrieben wurde.

Aus der Figur 1a ist die erfindungsgemäße Anordnung von ersten und zweiten Kontaktflächen 21, 31 gut ersichtlich. Einander zugeordnete erste und zweite Kontaktflächen 21, 31 überdecken sich vollständig, um eine Beschädigung der zweiten Kontaktflächen 31 aufgrund einwirkender Biegebelastungen zu vermeiden.

Würden sich die zweiten Kontaktflächen 31 über die Isolationsschlitze 22 hinweg erstrecken, so könnten diese bei auftretenden Biegungen beschädigt werden, da die Isolationsschlitze, wie eingangs erläutert, Sollbiegestellen darstellen. Bei auf das Trägersubstrat einwirkenden Biegebelastungen würde dieses somit im Bereich der Isolationsschlitze abknikken und somit zu einer Überdehnung oder Stauchung der zweiten Kontaktflächen 31 führen.

Figur 1b zeigt ein erfindungsgemäßes Chipmodul, bei dem auf die Einsatzseite 13 ein Chip 40 aufgebracht wurde. Der Chip 40 überdeckt dabei sämtliche Kontaktstellen 32 der zweiten Kontaktflächen 31, um eine Flip-Chip-Kontaktierung zu ermöglichen. Weiterhin definieren die Seitenränder des Chips 40 einen Chipaufnahmebereich I, der durch eine gekreuzte Schraffierung angedeutet ist. Der Chipaufnahmebereich I ist in einem Bereich II (schräg schraffiert) gelegen, welcher den Verlauf einer inneren Kavität 53 eines Chipkartenkörpers (vergleiche Figur 2) darstellt. Erfindungsgemäß soll in diesem Bereich II eine vollständige Überdeckung zwischen einander zugeordneten ersten und zweiten Kontaktflächen 21, 31 gegeben sein. Der übrige nicht schraffierte Bereich, welcher mit III gekennzeichnet ist, stellt den Modulmontagebereich dar, der besser aus der Figur 2 ersichtlich ist. In diesem Bereich überdecken sich der Boden der äußeren Kavität 54 und das Trägersubstrat 10, so daß eine mechanische Befestigung über ein Verbindungsmaterial 55 erfolgen kann.

In dem Chipaufnahmebereich I und dem Modulmontagebereich III ist eine ausreichende Stabilität bei einer auftretenden Biegebelastung gewährleistet, so daß eine Überdeckung jeweils zugeordneter ersten und zweiten Kontaktflächen 21 und 31 nicht unbedingt notwendig ist. Die mechanische Stabilität des Chipmodules bzw. Trägersubstrates kann jedoch auch in diesen Bereichen durch eine Überdeckung jeweils zugeordneter Kontaktflächen erzielt werden.

Erfindungsgemäß ist also ein zweiseitig metallisiertes Trägersubstrat vorgesehen, bei dem sich einander zugeordnete erste und zweite Kontaktflächen grundsätzlich nicht über benachbarte Isolationsschlitze erstrecken. Insbesondere soll eine Kreuzung von Isolationsschlitzen und zweiten Kontaktflächen in einem Bereich ausgeschlossen sein, der nicht durch einen Chipaufnahmebereich oder einen Modulmontagebereich gebildet ist.

### Bezugszeichenliste

- 1: Chipmodul

- 10: Trägersubstrat
- 12: Kontaktflächenseite
- 13: Einsatzseite
- 14: Ausnehmung, aufgefüllt mit einem Kontaktmaterial
- 15: Kontaktmaterialelement

- 20: Kontaktflächenmetallisierung
- 21: Erste Kontaktflächen
- 22: Isolationsschlitze / -stege

- 30: Einsatzseitenmetallisierung
- 31: Zweite Kontaktflächen
- 32: Kontaktstelle

- 40: Chip
- 41: Kontaktpunkte
- 42: Kontaktelement

- 50: Kartenkörper
- 51: Oberfläche
- 52: Kavität
- 53: Innere Kavität
- 54: Äußere Kavität
- 55: Verbindungsmaterial

- I II: Chipaufnahmebereich
- III: Montagebereich

## Patentansprüche

1. Elektrisch isolierendes Trägersubstrat (10) für ein Chipmodul, das auf einer Kontaktseite (12) eine Kontaktseitenmetallisierung (20) mit elektrisch voneinander getrennten ersten Kontaktflächen (21) und auf einer der Kontaktseitenmetallisierung (20) gegenüberliegenden Einsatzseite (13) eine Einsatzseitenmetallisierung (30) mit elektrisch voneinander getrennten zweiten Kontaktflächen (31) aufweist, wobei zumindest einigen der ersten Kontaktflächen (21) jeweils eine der zweiten Kontaktflächen (31) zugeordnet ist,**dadurch gekennzeichnet, daß** diese ersten Kontaktflächen (21), die jeweils zugeordnete zweite Kontaktfläche (31) zumindest außerhalb eines Chipaufnahmebereiches (I) und außerhalb eines Modulmontagebereiches (III) jeweils vollständig überdecken.

2. Trägersubstrat nach Anspruch 1, bei dem sich die einander zugeordneten Kontaktflächen (21, 31) im Chipaufnahmebereich (I) überdecken.

3. Trägersubstrat nach Anspruch 1 oder 2, bei dem sich die einander zugeordneten Kontaktflächen (21, 31) im Modulmontagebereich (III) überdecken.

4. Trägersubstrat nach einem der Ansprüche 1 bis 3, bei dem je eine erste Kontaktfläche (21) einer zweiten Kontaktfläche (31) zugeordnet ist.

5. Trägersubstrat nach einem der Ansprüche 1 bis 4, bei dem zwischen einander zugeordneten Kontaktflächen (21, 31) mittels eines Kontaktmaterialelementes (15) eine elektrische Verbindung hergestellt ist.

6. Trägersubstrat nach Anspruch 5, bei dem die Kontaktmaterialelemente (15) im Modulmontagebereich (III) des Trägersubstrates (10) vorgesehen sind.

7. Trägersubstrat nach einem der Ansprüche 1 bis 6, bei dem das Trägersubstrat (10) aus Polyester besteht.

8. Chipmodul zum Einsetzen in einen Chipkartenkörper (50) mit einem Trägersubstrat (10) gemäß einem der Ansprüche 1 bis 7, auf dessen Einsatzsatzseite (13) zumindest ein Chip (40) aufgebracht ist, der auf einer Hauptseite Kontaktpunkte (41) aufweist, von denen zumindest einige über Kontaktelemente (42) mit den zweiten Kontaktstellen (31) elektrisch verbunden sind.

9. Chipmodul nach Anspruch 8, bei dem die Kontaktelemente (42) Bumps sind.

10. Chipkarte mit einem Kartenkörper (50), in dessen Oberfläche eine Kavität (52) ausgebildet ist, in die ein Chipmodul (1) gemäß Anspruch 8 oder 9 in eingebracht ist, wobei eine mechanische Halterung des Chipmoduls an dem Kartenkörper (50) über dessen Modulmontagebereich (III) vorgesehen ist.

11. Chipkarte nach Anspruch 10, bei dem die Kavität zweistufig ausgebildet ist.

## Claims

1. Electrically isolating mounting substrate (10) for a chip module which, on a contact face (12), has contact face metallization (20) with first contact surfaces (21) which are electrically isolated from one another and, on a usage face (13) which is opposite the contact face metallization (20), has usage face metallization (30) with second contact surfaces (31) which are electrically isolated from one another, with at least some of the first contact surfaces (21) being associated with the use of the second contact surfaces (31) in each case, **characterized in that** these first contact surfaces (21) in each case completely cover the respectively associated second contact surface (31) at least outside a chip accommodation area (I) and outside a module mounting area (III).

2. Mounting substrate according to Claim 1 in which the mutually associated contact surfaces (21, 31) cover one another in the chip accommodation area (I).

3. Mounting substrate according to Claim 1 or 2, in which the mutually associated contact surfaces (21, 31) cover one another in the module mounting area (III).

4. Mounting substrate according to one of Claims 1 to 3, in which each first contact surface (21) has an associated second contact surface (31).

5. Mounting substrate according to one of Claims 1 to 4, in which an electrical connection is produced between mutually associated contact surfaces (21, 31) by means of a contact material element (15).

6. Mounting substrate according to Claim 5 in which the contact material elements (15) are provided in the module mounting area (III) of the mounting substrate (10).

7. Mounting substrate according to one of Claims 1 to 6, in which the mounting substrate (10) is composed of polyester.

8. Chip module for insertion into a smart card body (50) having a mounting substrate (10) according to one of Claims 1 to 7, on whose usage face (13) at least one chip (40) is mounted, which has contact points (41) on a main face, at least some of which are electrically connected to the second contact points (31) via contact elements (42).

9. Chip module according to Claim 8, in which the contact elements (42) are bumps.

10. Smart card having a card body (50) in which surface a cavity (52) is formed, in which a chip module (1) according to Claim 8 or 9 is introduced, with mechanical retention for the chip module being provided on the card body (50) via its module mounting area (III).

11. Smart card according to Claim 10, in which the cavity is formed with two steps.

## Revendications

1. Substrat (10) de support isolant du point de vue électrique pour un module de puce qui a, sur une face (12) de contact, une métallisation (20) de face de contact ayant des premières surfaces (21) de contact séparées les unes des autres et, sur une face (13) d'insertion opposée à la métallisation (20) de la face de contact, une métallisation (30) de face d'insertion ayant des deuxièmes surfaces (31) de contact séparées électriquement les unes des autres, dans lequel au moins certaines des premières surfaces (21) de contact sont associées, respectivement, à l'une des deuxièmes surfaces (31) de contact, **caractérisé en ce que** ces premières surfaces (21) de contact recouvrent entièrement les deuxièmes surfaces (31) de contact associées, respectivement, au moins à l'extérieur d'une zone (I) de réception d'une puce et à l'extérieur d'une zone (III) de montage d'un module.

2. Substrat de support suivant la revendication 1, dans lequel les surfaces (21, 31) de contact mutuellement associées se recouvrent dans la zone (I) de réception d'une puce.

3. Substrat de support suivant la revendication 1 ou 2, dans lequel les surfaces (21, 31) de contact associées mutuellement se recouvrent dans la zone (III) de montage d'un module.

4. Substrat de support suivant l'une des revendications 1 à 3, dans lequel, respectivement, une première surface (21) de contact est associée à une deuxième surface (31) de contact.

5. Substrat de support suivant l'une des revendications 1 à 4, dans lequel il est ménagé entre des surfaces (21, 31) de contact associées mutuellement une liaison électrique au moyen d'un élément (15) en matériau de contact.

6. Substrat suivant la revendication 5, dans lequel les éléments (15) en matériau de contact sont prévus dans la zone (III) de montage d'un module du substrat (10) de support.

7. Substrat suivant l'une des revendications 1 à 6, dans lequel le substrat (10) de support est en polyester.

8. Module de puce à insérer dans un corps (50) de carte à puce ayant un substrat (10) de support suivant l'une des revendications 1 à 7, sur la face (13) d'insertion est déposée au moins une puce (40) qui a sur une face principale des points (41) de contact dont certains au moins sont reliés électriquement au deuxième point (31 ) de contact par des éléments (42) de contact.

9. Module de puce suivant la revendication 8, dans lequel les éléments (42) de contact sont des bossages.

10. Carte à puce ayant un corps (50) de carte dans la surface duquel est constituée une cavité (52) dans laquelle est inséré un module (1) de puce suivant le revendication 8 ou 9, une fixation mécanique du module de puce sur le corps (50) de carte étant prévue au-dessus de sa zone (III) de montage d'un module.

11. Carte à puce suivant la revendication 10, dans laquelle la cavité est à deux paliers.
